**Europäisches Patentamt**

(19) **European Patent Office**

**Office européen des brevets**

(11) Numéro de publication: **0 131 513**
**B1**

(12) **FASCICULE DE BREVET EUROPEEN**

(45) Date de publication du fascicule du brevet:
**16.09.87**

(51) Int. Cl.⁴: **C 23 C 14/56**, C 23 C 14/32

(21) Numéro de dépôt: **84401429.0**

(22) Date de dépôt: **05.07.84**

(54) **Procédé et dispositif d'imprégnation métallique d'un substrat se présentant sous la forme d'une nappe de fibres conductrices du courant électrique.**

(30) Priorité: **07.07.83 FR 8311336**

(43) Date de publication de la demande:
**16.01.85 Bulletin 85/3**

(45) Mention de la délivrance du brevet:
**16.09.87 Bulletin 87/38**

(84) Etats contractants désignés:
**BE DE GB IT SE**

(56) Documents cités:
**FR - A - 979 772**
**FR - A - 2 079 401**
**FR - A - 2 335 615**
**FR - A - 2 395 327**
**US - A - 3 587 728**
**US - A - 3 750 623**

**PATENTS ABSTRACTS OF JAPAN, vol. 4, no. 30
(C-2)[512], 15 mars 1980, page 122 C 2**

(73) Titulaire: **AEROSPATIALE Société Nationale Industrielle, 37, Boulevard de Montmorency, F-75781 Paris Cédex 16 (FR)**

(72) Inventeur: **Coffy, René Louis, 13, rue les Lauriers, F-13960 Sausset les Pins (FR)**

(74) Mandataire: **Lepeudry-Gautherat, Thérèse et al, ARMENGAUD JEUNE CABINET LEPEUDRY 6, rue du Fg. St-Honoré, F-75008 Paris (FR)**

## Description

La présente invention concerne un dispositif pour imprégner de métal un produit se présentant sous la forme d'une nappe de fibres, tissées ou non, conductrices électriquement telles que du graphite, du bore ou du carbure de silicium.

Il existe en effet un besoin dans notamment l'industrie aéronautique, de matériaux très résistants et de faible masse.

On utilise couramment, en particulier dans l'industrie aéronautique, des matériaux composites généralement constitués par des fibres synthétiques à hautes ou trés hautes performances mécaniques, telles que des fibres de verre, de carbone, ou équivalents, agglomérées dans une matrice de résine synthétique polymérisée à chaud. Ces matériaux composites permettent de réaliser, de façon satisfaisante en ce qui concerne la résistance et la faible masse, une grande variété de pièces devant résister à de fortes contraintes statiques et/ou dynamiques.

Cependant, compte tenu des caractéristiques propres de la résine synthétique utilisée et, en particulier, de sa tenue limitée en température et au vieillissement, on ne peut en pratique utiliser ces stratifiés lorsque la température ambiante dépasse 100 °C.

Par ailleurs, les caractéristiques de tenue mécanique de la résine, en particulier au cisaillement, sont relativement faibles et limitent la résistance d'ensemble des pièces réalisées avec des composites de telle facture.

Pour remédier à ces inconvénients, on a cherché à remplacé la matrice en résine synthétique par du métal léger, en particulier de l'aluminium, dont la tenue à la température et la résistance mécanique sont largement supérieures à celles des résines synthétiques.

C'est ainsi qu'une nouvelle technologie est née pour mettre au point ces matériaux associant des fibres à haute résistance avec un métal. Cette association est généralement réalisée aujourd'hui par trempage des fibres dans un bain de métal fondu avec au préalable de nombreux traitements des fibres d'une part pour éviter leur détérioration par oxydation, et d'autre part, pour favoriser la pénétration du métal dans tous les pores du substrat et son accrochage aux fibres.

On connaît par le FR-A 2 395 327 un procédé de dépôt métallique sur un substrat qui consiste à placer ce dernier dans une atmosphère inerte, à créer une différence de potentiel entre ce substrat et une anode placée dans ladite atmosphère, et à apporter le métal d'imprégnation par placage ionique sur ledit substrat, un apport de calories servant à maintenir la température d'évaporation.

La présente invention a pour objet de réaliser cette imprégnation avec un dispositif qui permette de supprimer les phases de préparation souvent longues et coûteuses tout en conservant, voire en augmentant la qualité du demi-produit final. Elle parvient à ce résultat au moyen d'un seul appareillage ce qui constitue une grande simplification de l'équipement de fabrication. Elle permet enfin de s'affranchir de la sujétion coûteuse des techniques connues d'entretien d'un ou plusieurs bains de métal et sels fondus en grande quantité.

Ainsi, plus précisément l'invention a pour objet un dispositif pour procéder à l'imprégnation métallique d'un substrat dans les conditions indiquées dans le préambule de la revendication 1 et qui comporte:

— une enceinte pourvue de moyens pour sa fermeture étanche dans laquelle débouchent une canalisation de mise sous vide et un conduit d'amenée d'un gaz neutre,

— un dispositif de support du substrat constitué par un chariot mobile entre une première position à l'intérieur de l'enceinte et une seconde position à l'extérieur de l'enceinte, au travers des moyens de fermeture susdits et par des moyens de guidage du chariot par rapport à l'enceinte lors de son mouvement de l'une vers l'autre des positions susdites, ledit chariot étant équipé de moyens pour recevoir à rotation une bobine de nappe à dérouler et une bobine d'enroulement de cette nappe, espacés l'un de l'autre et des moyens de guidage de ladite nappe s'étendant entre elles dans un plan fixe par rapport au chariot et parallèle à son déplacement,

— au moins un creuset de réception du métal fondu solidaire de ladite enceinte à l'intérieur de celle-ci et situé parallèlement au et à proximité du plan susdit de la nappe lorsque le chariot est dans sa première position,

— des moyens d'isolation électrique en forme de manchon isolant desdites bobines par rapport audit chariot,

— et des moyens de contact électrique reliant une bobine à une source de potentiel lorsque le chariot est dans sa première position sudite, constitués d'un conducteur à contact frottant avec une bague du cylindre de la bobine, et d'une prise isolée électriquement de l'enceinte sur laquelle elle est fixée.

Dans un mode préféré de réalisation, ledit dispositif comporte deux creusets disposés de part et d'autre du plan susdit.

Par ailleurs, les moyens du chariot destinés à recevoir à rotation lesdites bobines possèdent un dispositif de liaison à au moins un arbre moteur situé à l'intérieur de ladite enceinte.

Ledit dispositif de liaison est accouplé audit arbre lorsque le chariot est dans sa première position et désaccouplé de cet arbre lorsque le chariot est dans une position autre.

Il est, en outre, avantageux que le chariot susdit possède des moyens de confinement de l'atmosphère intérieure de l'enceinte constitués par des écrans latéraux disposés au voisinage de la partie de nappe située dans le plan susdit et délimitant un volume de part et d'autre de ce plan dans lequel est placé le ou chacun desdits creusets lorsque le chariot est dans sa première position.

On notera qu'au moins une partie des volets susdits est articulée audit chariot pour permettre l'accès latéral à ce dernier lors du chargement et du déchargement des bobines dans sa seconde position.

Enfin, le dispositif selon l'invention comporte un dispositif d'alimentation sous forme d'un fil métallique du ou de chacun des creusets susdits, solidaire des parois de ladite enceinte, à l'intérieur de celle-ci.

L'invention sera mieux comprise au cours de la description donnée ci-après à titre d'exemple purement indicatif et non limitatif qui permettra d'en dégager les avantages et les caractéristiques secondaires.

Il sera fait référence aux dessins annexés dans lesquels:

- la figure 1 est une vue extérieure partiellement arrachée du dispositif selon l'invention,

- la figure 2 est une vue en coupe du dispositif de la figure 1, le chariot étant dans sa seconde position,·

- la figure 3 est une coupe suivant la ligne III—III de la figure 2,

- la figure 4 est une vue en coupe du dispositif de la figure 1, le chariot étant dans sa première position,

- la figure 5 est une coupe suivant la ligne V–V de la figure 4,

- la figure 6 est une vue de détail illustrant l'accouplement mécanique et la connexion électrique des organes d'enroulement du chariot quand celui-ci est dans sa première position susdite.

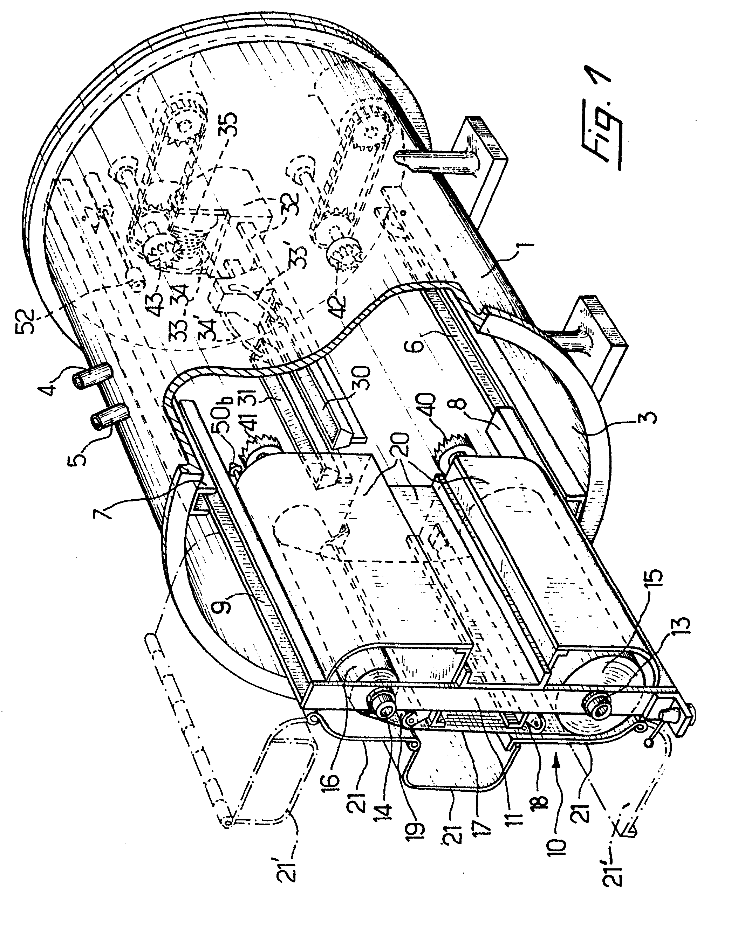

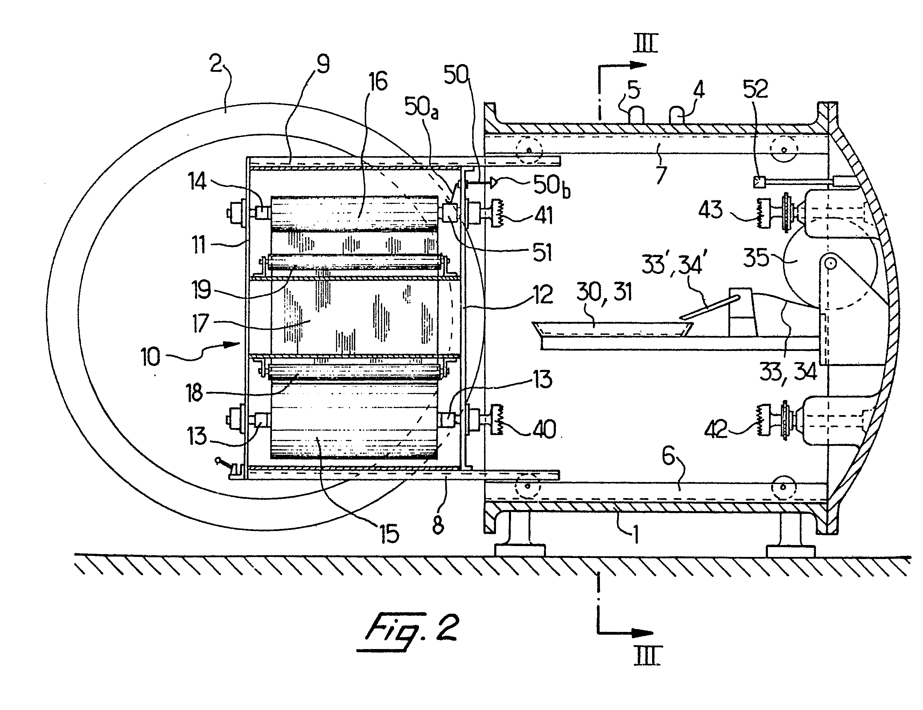

En se reportant tout d'abord aux figures 1 et 2, on voit un dispositif selon l'invention qui comporte une enceinte 1 sensiblement cylindrique dont l'un des fonds, au moins, 2 est ouvrant et forme porte d'obturation étanche d'une ouverture 3 d'accès à l'intérieur de l'enceinte. Cette enceinte est pourvue d'une première canalisation 4 de mise sous vide de son volume intérieur (par le moyen d'un dispositif non représenté) et d'une seconde canalisation 5 qui constitue un conduit d'amenée d'un gaz neutre.

La partie inférieure et la partie supérieure de l'enceinte sont équipées de rails de guidage respectivement 6 et 7 susceptibles de recevoir à coulissement des éléments de guidage correspondant 8 et 9 d'un chariot 10. Ce chariot peut donc être logé (première position) dans ou extrait (deuxième position telle que représentée) hors de l'enceinte par translation le long de l'axe de l'enceinte 1, grâce à ces éléments de guidage qui assurent en outre le maintien stable du chariot en porte-à-faux dans sa deuxième position. La représentation des moyens de guidage est à prendre dans son principe et souffre de nombreuses variantes connues en elles-mêmes.

Le chariot 10 est, quant à lui, constitué principalement par deux supports d'extrémité 11 et 12 disposés entre les rails de guidage, équipés de moyens inférieurs 13 et supérieurs 14 pour recevoir à rotation, et de manière démontable rapidement, deux cylindres formant le cœur de deux bobines 15 et 16, d'enroulement et de déroulement du substrat 17 se présentant sous la forme d'une nappe de fils ou fibres conducteurs. Ainsi on peut mettre en place sur le chariot une bobine pleine 15 au moyen des organes 13 d'accouplement et un rouleau vide au niveau des organes 14 d'enroulement du substrat se déroulant de la bobine 15 pour former une bobine 16. Entre les deux bobines, la nappe 17 suit un trajet sensiblement vertical délimité par des rouleaux de tension et de réglage 18 et 19 portés par ledit chariot. La position de nappe 17 située entre les deux rouleaux 18 et 19 se trouve donc maintenue dans un plan vertical légèrement déporté latéralement par rapport à l'armature du chariot 10 pour qu'un espace suffisant soit ménagé entre cette armature et le plan de la nappe. Le chariot comporte en outre un système de capotage latéral des zones d'enroulement, de défilement et de déroulement de la nappe, constitué par ensemble de plaques 20 fixes par rapport à l'armature du chariot situé d'un côté de celle-ci et par un ensemble de volets mobiles 21 articulés les uns aux autres qui dans une première position sont essentiellement symétriques de l'ensemble de plaques 20 par rapport à l'armature du chariot et dans une seconde position (21' sur la figure 1) sont basculés autour de leurs articulations pour permettre un accès latéral sans obstacle audit chariot pour notamment le chargement et le déchargement des bobines et cylindres. On remarquera sur la figure 1 que le volet central, adjacent à la partie de nappe 17 située entre les deux rouleaux 18 et 19, délimite avec cette partie un volume en saillie par rapport au capotage des bobines 15 et 16 dont le rôle sera explicité ci-après. Un volume sensiblement correspondant est ménagé entre l'autre face de la nappe et la partie centrale du capotage 20.

A l'intérieur de l'enceinte 1, on a disposé deux creusets 30, 31 parallèles à son axe longitudinal. Ces creusets sont maintenus rigidement au moyen d'une console 32 solidaire du fond non-ouvrant de l'enceinte. Il n'est pas représenté sur ces figures un moyen de chauffage par effet joule desdits creusets dont la puissance est suffisante pour maintenir à l'état fondu, et à une température au moins égale à sa température de vaporisation, un métal déterminé disposé dans ces creusets. Ce métal sera de préférence amené dans chacun des creusets sous la forme d'un fil 33, 34 délivré à partir d'une bobine de stockage 35 solidaire de la console 32 au moyen d'un dispositif de dévidement non représenté, et guidé vers chacun des creusets par un organe tubulaire 33', 34'.

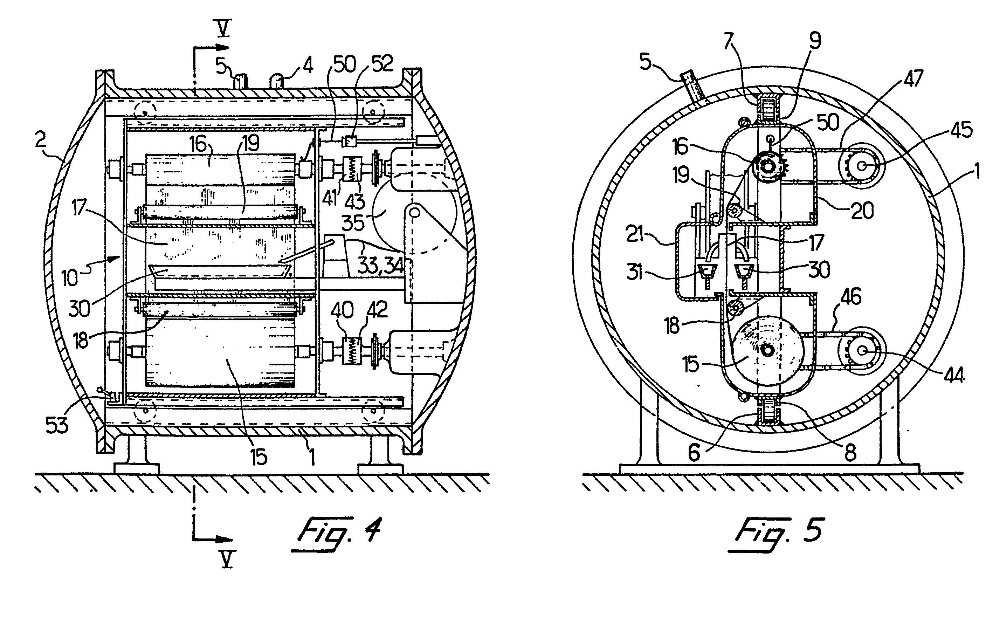

Il faut noter par ailleurs que la localisation des creusets 30, 31 dans l'enceinte est telle que le plan vertical de la nappe entre les deux rouleaux tendeurs passe entre les deux creusets lorsque le chariot 10 est dans sa première position susdite (voir figure 5). En outre, l'altitude des creusets 30, 31 par rapport à la partie inférieure de l'enceinte est telle que ceux-ci sont situés à l'intérieur des volumes délimités de part et d'autre de la partie verticale de la nappe 17 par les parties centrales des capots 20 et 21 (voir également figure 5).

On remarquera également sur ces figures 1 et 2 que les moyens 13 et 14 de support des cylindres d'enroulement et de déroulement de la nappe sur le chariot 10 possèdent, du côté du chariot tourné vers l'intérieur de l'enceinte, un organe d'accouplement 40, 41 susceptible de coopérer avec un organe correspondant 42, 43 prévu à l'extrémité intérieure fermée de l'enceinte lorsque le chariot 10 est dans sa position intérieure à l'enceinte 1. Ces dispositifs 40 à 43 permettent une liaison ou un découplement automatique des cylindres porteurs de la nappe avec des organes moteurs d'entrainement de leur rotation pour l'opération d'enroulement—déroulement de la nappe.

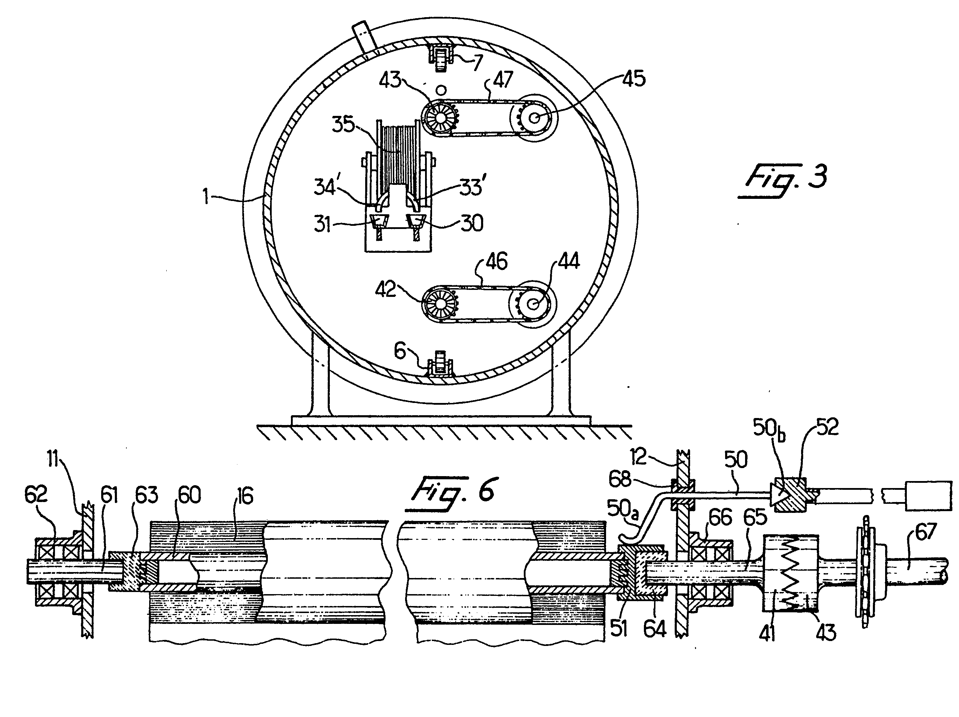

Sur la figure 3 on a représenté, outre certains des éléments déjà décrits avec les mêmes références, la liaison entre les dispositifs d'accouplement 42 et 43 et des arbres moteurs 44 et 45 au moyen de chaînes 46, 47.

Revenant enfin aux figures 1 et 2, on notera que le chariot est équipé d'un élément de liaison électrique 50 constitué par un conducteur dont une extrémité 50a assure un contact frottant avec une bague 51 du cylindre de la bobine 16 et l'autre extrémité 50b se trouve en projection horizontale au-delà du montant d'armature 12 du chariot 10. Cette extrémité 50b constitue une fiche de connexion du conducteur 50 avec une prise 52 fixe solidaire de l'enceinte lorsque le chariot est dans sa première position. Le conducteur 50 et la prise 52 sont électriquement isolés respectivement du chariot 10 et de l'enceinte 1.

Les figures 4 et 5 représentent le dispositif de l'invention dans sa position active c'est-à-dire en cours d'imprégnation du substrat. On retrouve sur ces figures la plupart des éléments déjà décrits avec les mêmes références, la porte 2 de l'enceinte étant fermée, l'accouplement des organes 40, 42 et 41, 43 et la connexion électrique entre la fiche 50b et la prise 52 étant réalisés. On rappelera la disposition relative de chacun des creusets 30, 31 de part et d'autre du plan vertical de défilement de la nappe 17. On notera enfin schématisé en 53, un dispositif de verrouillage du chariot dans sa première position.

La figure 6 illustre de manière détaillée le support d'un cylindre d'enroulement de la nappe (ici au niveau de la bobine 16) par le chariot 10, dans la première position du chariot et les dispositions d'isolation électrique qu'il comporte. Ainsi la bobine 16 est formée autour d'un cylindre 60 métallique. Ce cylindre est attelé au tourillon 61 d'un pallier 62 porté par le montant 11 du chariot au moyen d'une pièce 63 en forme de bague ou de manchon en matériau isolant solidaire du cylindre 60. Du côté du montant 12 le cylindre 60 est au contact de la bague de frottement métallique 51 donc en continuité électrique avec elle qui porte, à l'instar de son autre extrémité, un manchon isolant qui coopère avec l'extrémité 65 d'un arbre traversant le montant 12 dans un palier 66.

On aura prévu un dispositif d'écartement du tourillon libre 61 de l'arbre 65 pour permettre le retrait ou l'emmanchement du cylindre entre leurs extrémités. La liaison en rotation entre l'arbre 65 et le cylindre 60 peut être réalisée par un crabotage entre la bague 51 et le cylindre 60, la bague étant solidaire, par exemple, dudit arbre.

L'arbre 65 est équipé à son autre extrémité de l'organe d'accouplement automatique 41 qui coopère avec l'organe semblable 43 porté par un arbre moteur 67. Les mêmes dispositions sont prévues pour le cylindre de la bobine inférieure 15 à l'exception de la bague de frottement 51. On retrouve également sur cette figure 6 le conducteur 50 porté par le montant 12 au moyen d'une bague d'isolation 68 et la prise formelle 52.

On décrira ci-après le fonctionnement du dispositif d'imprégnation métallique selon l'invention.

Le chariot 10 étant placé dans sa position des figures 1 et 2, les volets 21 étant relevés on met en place la bobine 15 constituée par l'enroulement d'une nappe de fibres conductrices, tissées ou non, courtes ou longues dont on enroule l'extrémité libre autour du cylindre 60 par dessus les rouleaux tendeurs 18 et 19.

Le chariot est ensuite glissé à l'intérieur de l'enceinte 1 dont le fond 2 est refermé. Au moyen de la conduite 4, on crée dans l'enceinte un vide partiel de l'ordre de $10^{-2}$ Pa puis l'on introduit dans l'enceinte par la conduite 5 un gaz neutre jusqu'à l'établissement d'une pression de l'ordre de 1 Pa. On établit alors entre les creusets 30, 31 et le substrat, par l'intermédiaire du conducteur 50, une différence de potentiel de l'ordre de 1500 à 2000 V. Le champ électrique intense ainsi établi crée un plasma du gaz raréfié dans l'enceinte dont l'un des effets est de créer un décapage du substrat par bombardement ionique du substrat. On peut donc réaliser un premier défilement de la nappe entre la bobine 15 et la bobine 16 à ce seul effet de décapage et préparation en commandant la rotation des cylindres des bobines au moyen des arbres moteurs tels que 67.

On procède ensuite à l'approvisionnement des creusets 30, 31 en métal, par déroulement de la bobine 35, et l'on porte ce métal, par apport de calories au niveau des creusets, à sa température d'évaporation. La différence de potentiel est alors réglée entre 500 et 1500 V. Les atomes de métal vaporisé sont alors partiellement ionisés dans le plasma de gaz raréfié et les ions positifs ainsi créés sont accélérés et attirés par le substrat qui est l'électrode négative de l'ensemble. Grâce au champ électrique intense créé autour du substrat la directivité des particules de métal est faible ce qui permet d'assurer un recouvrement uniforme du substrat. On notera à cet égard que les capots 20, 21 qui sont à la masse forment un confinement de la zone d'atmosphère électrique autour du substrat 17. L'évaporation de métal est compensée par l'alimentation automatique des creusets en fil métallique et le substrat est entraîné entre les deux creusets au moyen des organes d'entraînement des cylindres de bobine. Les ions du gaz raréfié et les ions métalliques évaporés libèrent leur énergie sous forme de chaleur au contact de la surface du substrat qu'ils échauffent en favorisant ainsi l'adhérence du métal sur le support.

Par ailleurs, le réglage de la vitesse de défilement de la nappe permet d'obtenir des variations dans le degré d'imprégnation que l'on désire obtenir.

Après l'imprégnation, on procède à l'extraction du chariot 10, ce qui le déconnecte de la source de tension, puis au déchargement du produit fini pour le remplacer par un produit à imprégner. On notera qu'avec un système de sas approprié, au niveau de l'ouverture 3, on pourra préserver au moins une partie du vide réalisé dans l'enceinte 1 lors des opérations de chargement.

L'un des avantages de l'utilisation du dispositif selon l'invention réside dans le fait que le bombardement par les ions positifs du gaz raréfié du substrat constitue un excellent décapage de la surface de ce dernier qui est un facteur d'amélioration de l'adhérence du métal à déposer, sans toutefois dégrader le substrat. On évite ainsi tous les traitements préalables qui sont normalement mis en œuvre dans les dispositifs connus d'imprégnation. En outre, la chaleur dégagée à la surface du substrat par l'énergie des ions métalliques et gazeux est également un facteur d'amélioration de l'adhérence du métal déposé.

Le produit ainsi obtenu présente un revêtement ou une imprégnation dosé de façon très précise qui peut ainsi convenir dans de nombreuses applications, comme produit semi-fini pour la production industrielle de pièces aéronautiques résistantes et de faible masse. Les fibres mises en œuvre, pourront être en carbone, en bore ou tout autre matériau conducteur. La matrice métallique pourra être de l'aluminium ou du cadmium.

L'invention trouve une application intéressante dans le domaine de la fabrication de demi-produits pour l'aéronautique.

**Revendications**

1. Dispositif pour procéder à l'imprégnation métallique d'un substrat se présentant sous la forme d'une nappe de fibres conductrices dans une atmosphère inerte sous vide partiel, une différence de potentiel étant créée entre ledit substrat (cathode) et une électrode (anode) placées dans ladite atmosphère, le métal d'imprégnation étant apporté à partir d'un creuset sous forme fondue dans ladite atmosphère au même potentiel que celui de l'anode, dispositif dans lequel une enceinte (1) est pourvue de moyens (2, 3) pour sa fermeture étanche et dans laquelle débouchent une canalisation (4) de mise sous vide et un conduit (5) d'amenée d'un gaz neutre, caractérisé en ce qu'il comporte:

— un dispositif de support du substrat (17) constitué par un chariot mobile (10) entre une première position à l'intérieur de l'enceinte (1) et une seconde position à l'extérieur de l'enceinte au travers des moyens (2, 3) de fermeture susdits et par des moyens de guidage (6, 7, 8, 9) du chariot par rapport à l'enceinte (1) lors de son mouvement de l'une vers l'autre des positions susdites, ledit chariot (10) étant équipé de moyens (13, 14) pour recevoir à rotation une bobine (15) de nappe (17) à dérouler et une bobine (16) d'enroulement de cette nappe, espacés l'un de l'autre et des moyens de guidage (18, 19) de ladite nappe (17) s'étendant entre elles dans un plan fixe par rapport au chariot (10) et parallèle à son déplacement,

— au moins un creuset (30, 31) de réception du métal fondu solidaire de ladite enceinte (1) à l'intérieur de celle-ci et situé parallèlement au et à proximité du plan susdit de la nappe (17) lorsque le chariot est dans sa première position,

— des moyens d'isolation électrique en forme de manchon isolant (63, 64) desdites bobines (15, 16) par rapport audit chariot (10),

— et des moyens de contact électrique, reliant une bobine (16) à une source de potentiel lorsque le chariot est dans sa première position susdite, constitués d'un conducteur (50) à contact frottant avec une bague (51) du cylindre de la bobine (16), et d'une prise (52) isolée électriquement de l'enceinte sur laquelle elle est fixée.

2. Dispositif selon la revendication 1, caractérisé en ce qu'il comporte deux creusets (30, 31) disposés de part et d'autre du plan susdit.

3. Dispositif selon la revendication 1, caractérisé en ce que les moyens du chariot (10) destinés à recevoir à rotation lesdites bobines (15, 16) possèdent un dispositif de liaison (40, 41) à au moins un arbre (42, 43) moteur situé à l'intérieur de ladite enceinte.

4. Dispositif selon la revendication 3, caractérisé en ce que ledit dispositif de liaison (40, 41) est accouplé audit arbre (42, 43) lorsque le chariot (10) est dans sa première position et désaccouplé de cet arbre lorsque le chariot est dans une position autre.

5. Dispositif selon l'une quelconque des revendications 1 à 4, caractérisé en ce que le chariot (10) susdit possède des moyens (20, 21) de confinement de l'atmosphère intérieure de l'enceinte (1) constitués par des écrans latéraux disposés au voisinage de la partie de nappe (17) située dans le plan susdit et délimitant un volume de part et d'autre de ce plan dans lequel est placé le ou chacun desdits creusets (30, 31) lorsque le chariot (10) est dans sa première position.

6. Dispositif selon la revendication 5, caractérisé en ce qu'au moins une partie des écrans (21) susdits est articulée audit chariot (10) pour permettre l'accès latéral à ce dernier lors du chargement et du déchargement des bobines (15, 16) dans sa seconde position.

7. Dispositif selon l'une quelconque des revendications 1 à 6, caractérisé en ce qu'il comporte un dispositif d'alimentation (33', 34', 35) sous forme d'un fil métallique (33, 34) du ou de chacun des creusets (30, 31) susdits, solidaire des parois de ladite enceinte (1), à l'intérieur de celle-ci.

8. Utilisation d'un dispositif selon l'une quelconque des revendications 1 à 7 pour l'imprégnation métallique d'un substrat se présentant sous la forme d'une nappe de fibres conductrices.

**Patentansprüche**

1. Vorrichtung zum Imprägnieren eines in Form eines Vlieses aus leitfähigen Fasern vorliegenden Substrats mit Metall in einer inerten Atmosphäre unter teilweisem Vakuum, wobei zwischen dem genannten Substrat (Kathode) und einer in der genannten Atmosphäre angeordneten Elektrode (Anode) eine Spannungsdifferenz besteht und das Metall für die Imprägnierung in geschmolzener Form innerhalb der genannten Atmosphäre mittels eines Schmelztiegels unter der gleichen Spannung wie jener der Anode zugeführt wird sowie die Vorrichtung ein Gehäuse (1) aufweist, das mit Mitteln (2, 3) zum dichten Verschliessen des Gehäuses ausgerüstet ist und in welches eine Vakuumableitung (4) sowie eine Zuleitung (5) für ein neutrales Gas einmünden, gekennzeichnet durch eine Einrichtung zum Tragen des Substrats (17), die aus einem Schlitten (10) besteht, welcher zwischen einer ersten Stellung innerhalb des Gehäuses (1) und einer zweiten Stellung ausserhalb dieses Gehäuses über die Mittel (2, 3) zum Verschliessen des Gehäuses hinweg mit Hilfe von Führungsmitteln (6, 7, 8, 9) für den Schlitten zur Zeit seiner Bewegung von der einen zu der anderen der genannten Stellungen bezüglich des Gehäuses (1) beweglich ist, der Schlitten (10) mit voneinander beabstandeten Mitteln (13, 14) zur drehbaren Aufnahme einer Abwickelspule (15) und einer Aufwickelspule (16) für das Vlies (17) sowie mit Führungsmitteln (18, 19) für das Vlies (17) ausgerüstet ist, das sich zwischen ihnen innerhalb einer festen Ebene bezüglich des Schlittens (10) und parallel zu dessen Verschiebung erstreckt,

— mindestens einen Schmelztiegel (30, 31) zur Aufnahme von geschmolzenem Metall, der im Innern des Gehäuses (1) mit diesem fest verbundenen und parallel zu der vorgenannten Ebene des Vlieses (17) sowie in deren Nähe angeordnet ist, wenn sich der Schlitten in seiner ersten Stellung befindet,

— Mittel zur elektrischen Isolation in Form von Muffen (63, 64), welche die genannten Spulen (15, 16) gegenüber dem Schlitten (10) isolieren,

— und Mitteln für einen elektrischen Kontakt, welche die eine Spule (16) mit einer Spannungsquelle verbinden, wenn der Schlitten sich in der genannten ersten Stellung befindet, und welche aus einem Schleifkontakt (50) mit einem Schleifring (51) der Spule (16) sowie aus einer Steckdose (52), die gegenüber dem Gehäuse, an das sie befestigt ist, elektrisch isoliert ist, bestehen.

2. Vorrichtung nach Anspruch 1, gekennzeichnet durch zwei Schmelztiegel (30, 31), die zu beiden Seiten der genannten Ebene angeordnet sind.

3. Vorrichtung nach Anspruch 1, dadurch gekennzeichnet, dass die für die drehbare Aufnahme der genannten Spulen (15, 16) vorgesehenen Mittel des Schlittens (10) eine Einrichtung (40, 41) zum Verbinden mit mindestens einer Antriebswelle (42, 43), die im Innern des genannten Gehäuses angeordnet ist, aufweisen.

4. Vorrichtung nach Anspruch 3, dadurch gekennzeichnet, dass die genannte Verbindungseinrichtung (40, 41) an die erwähnte Antriebswelle (42, 43) angekuppelt ist, wenn sich der Schlitten (10) in seiner ersten Stellung befindet, und die Verbindungseinrichtung (40, 41) von dieser Antriebswelle abgekuppelt ist, wenn sich der Schlitten in einer anderen Stellung befindet.

5. Vorrichtung nach einem der Ansprüche 1 bis 4, dadurch gekennzeichnet, dass der Schlitten (10) Mittel (20, 21) zum Abgrenzen der Innenatmosphäre des Gehäuses (1) aufweist, die aus seitlichen Abschirmungen bestehen, welche in der Nähe des in der genannten Ebene befindlichen Teils des Vlieses (17) angeordnet sind, und diese Mittel beiderseits dieser Ebene ein Volumen abgrenzen, in dem der oder jeder der Schmelztiegel (30, 31) plaziert ist, wenn sich der Schlitten (10) in seiner ersten Stellung befindet.

6. Vorrichtung nach Anspruch 5, dadurch gekennzeichnet, dass mindestens ein Teil der genannten Abschirmungen (21) an dem Schlitten (10) aufklappbar sind, um einen seitlichen Zugang zum letzteren während des Einsetzens oder Abnehmens der Spulen (15, 16) in seiner zweiten Stellung zu erlauben.

7. Vorrichtung nach einem der Ansprüche 1 bis 6, gekennzeichnet durch eine Versorgungseinrichtung (33', 34', 35) in Form eines Metalldrahts (33, 34) für den oder jeden der genannten Schmelztiegel (30, 31), wobei diese Einrichtung im Innern des genannten Gehäuses (1) mit dessen Wänden fest verbunden ist.

8. Verwendung einer Einrichtung nach einem der Ansprüche 1 bis 7 zum Imprägnieren eines als Vlies aus leitfähigen Fasern vorliegenden Substrats mit Metall.

**Claims**

1. A device for carrying out metal impregnation of a substrate in the form of a sheet of conductive fibres in an inert atmosphere under a partial vacuum, a potential difference being created between said substrate (cathode) and an electrode (anode) placed in said atmosphere, the impregnating metal being brought from a crucible in molten form into said atmosphere at the same potential as that of the anode, there being in this device a chamber (1) provided with means (2, 3) for its tight closure and having opening into it a pipeline (4) for applying vacuum and a pipe (5) for supplying a neutral gas, characterized in that it comprises:

— a device for supporting the substrate (17), consisting of a carriage (10) movable between a first position inside the chamber (1) and a second position outside the chamber through the above-mentioned closing means (2, 3) and of means (6, 7, 8, 9) for guiding the carriage with respect to the chamber (1) when it moves from one to the other of the above-mentioned positions, said carriage (10) being equiped with means (13, 14) spaced in relation to each other for rotatably receiving a spool (15) for unwinding the sheet (17) and a spool (16) for winding up this sheet, and with means (18, 19) for guiding said sheet (17) extending between the spools (15, 16) in a plane fixed in relation to the carriage (10) and parallel to its displacement,

— at least one molten metal receiving crucible (30, 31) inside said chamber (1) and firmly connected thereto and situated in parallel to and in proximity to the above-mentioned plane of the sheet (17) when the carriage is in its first position,

— means, in the form of insulating sleeves (63, 64), of electrically insulating said spools (15, 16) with respect to said carriage (10),

– and means of electric contact, connecting one spool (16) to a potential source when the carriage is in its first above-mentioned position, consisting of a conductor (50) in frictional contact with a ring (51) on the cylinder of the spool (16) and a connector (52) insulated electrically from the chamber on which it is fixed.

2. A device according to claim 1, characterized in that it comprises two crucibles (30, 31) arranged on either side of the above-mentioned plane.

3. A device according to claim 1, characterized in that the means on the carriage (10) for rotatably receiving said spools (15, 16) comprise a device (40, 41) for connection to at least one drive shaft (42, 43) situated inside said chamber.

4. A device according to claim 3, characterized in that said connecting device (40, 41) is coupled to said shaft (42, 43) when the carriage (10) is in its first position and uncoupled from this shaft when the carriage is in another position.

5. A device according to any one of claims 1 to 4, characterized in that the above-mentioned carriage (10) has means (20, 21) for confining the inert atmosphere of the chamber (1), consisting of lateral screens which are arranged in the vicinity of the part of the sheet (17) situated in the above-mentioned plane and which define a volume on either side of this plane in which is positioned the or each of the crucibles (30, 31) when the carriage (10) is in its first position.

6. A device according to claim 5, characterized in that at least a part of the above-mentioned screens (21) is hinged to said carriage (10) to allow lateral access to the latter during loading and unloading of the spools (15, 16) in the second carriage position.

7. A device according to any one of claims 1 to 6, characterized in that it comprises a device (33', 34', 35) for the supply in the form of a metal wire (33, 34) of the or each of the above-mentioned crucibles (30, 31), which device (33', 34', 35) is located inside said chamber (1) and firmly connected to the walls thereof.

8. The use of a device according to any one of claims 1 to 7 for the metal impregnation of a substrate in the form of a sheet of conductive fibres.

Fig. 1

Fig. 2

*Fig. 3*

*Fig. 6*

Fig. 5

Fig. 4